# FASCICULE DE BREVET EUROPEEN

(11) **EP 2 121 512 B1**
(45) Date de publication et mention de la délivrance du brevet: **13.03.2013**
(21) Numéro de dépôt: 07847453.3
(22) Date de dépôt: 28.11.2007
(51) Int. Cl.: B81B 7/00, B81C 1/00

(54) **Boîtier de protection d'un micro-systeme électromécanique comportant un relais de cablage**
Schutzkasten für ein mikroelektromechanisches System mit einem Verdrahtungsrelais
Protection box for a microelectromechanical system including a wiring relay

(30) Priorité: 12.12.2006 FR 0610817
(43) Date de publication de la demande: 25.11.2009
(73) Titulaire: Thales, 92200 Neuilly Sur Seine (FR)
(72) Inventeur: PARBAUD, Serge, 26320 Saint Marcel Les Valence (FR); QUER, Régis, 07130 Saint Peray (FR); FOURRIER, Alain, 26000 Valence (FR)
(74) Mandataire: Esselin, Sophie
(86) Numéro de dépôt international: PCT/EP2007/062928
(87) Numéro de publication internationale: WO 2008/071545

(56) Documents cités:
- DE-A1- 10 054 964
- US-A1- 2005 218 509

## Description

Le domaine de l'invention est celui du câblage de micro-systèmes électromécanique encore appelés MEMS (acronyme pour Micro Electro Mechanical Systems) et plus particulièrement des micro-systèmes réalisant des mesures de grandeurs physiques comme par exemple des micro-gyromètres, des micro-accéléromètres ou des micro-capteurs de pression.

Les MEMS sont des systèmes qui sont très sensibles aux contraintes thermiques et mécaniques, c'est la raison pour laquelle il est nécessaire, pour les faire fonctionner, de les confiner dans un boîtier de protection étanche dans lequel règne une atmosphère contrôlée.

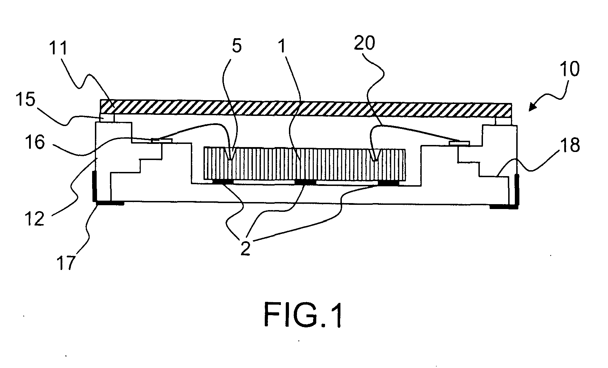

La figure 1 représente en vue de coupe transverse un tel boîtier de protection, 10. Le boîtier, 10 comporte un fond, 12 et un capot, 11 qui sont solidarisés par des brasures 15, le boîtier, 10 forme une enceinte close, dans laquelle une atmosphère contrôlée peut être installée.

Un micro-système électromécanique MEMS, 1 a en général une forme sensiblement plane comportant deux faces : en fait un micro-système électromécanique MEMS, 1 peut être composé d'une simple structure plane réalisées par usinage d'un substrat de silicium sur isolant (SOI) ou de quartz ou d'un autre matériau, mais d'autres méthodes sont également possibles, c'est le cas de certains micro-accéléromètres, ou encore peut être composé d'un empilement de plusieurs couches usiné de silicium, c'est le cas de certains micro-gyromètres.

Le micro-système électromécanique MEMS, 1 est enfermé dans le boîtier 10, Une première face du micro-système MEMS, 1 repose sur plusieurs reports 2. Les reports 2, sont eux-même placés sur une paroi interne du fond 12 du boîtier, 12. Les reports 2, sont des fixations par brasure qui isolent le micro-système MEMS 1, du boîtier 10. Les reports, 2 possèdent en général des hauteurs identiques de façon à minimiser les contraintes mécaniques et thermiques sur le micro-système MEMS, 1.

Une deuxième face du micro-système MEMS, comporte des contacts électriques micro-système, 5 qui constituent des entrées et des sorties électriques permettant respectivement d'adresser des signaux électriques de commande au micro-système, MEMS pour le faire fonctionner ou de véhiculer des signaux électriques produits par le micro-système, 1 hors du micro-système.

En général, des transferts de signaux électriques vers le micro-système MEMS, 1 et des transferts de signaux électriques provenant du micro-système MEMS, 1 sont réalisés par des liaisons filaires, 20 (connues communément sous l'appellation anglo-saxonne « bondings ») qui relient les contacts électriques micro-système, 5 et des contacts électriques internes 16, disposés sur des parois internes du boîtier. Les contacts électriques internes, 16 sont reliés électriquement, par l'intermédiaires de liaisons internes, 18, à des contacts électriques externes, 17 supportés par des parois externes du fond 12, du boîtier, 10. Les documents US 2005/0218509 A1 et DE 10054964 A1 décrivent des exemples de boîtiers ayant des liaisons filaires pour relier électriquement les MEMS et des contacts életriques internes du boîtier.

électriques internes du boîtier.

Les contacts électriques micro-système, 5 occupent, sur la deuxième face du micro-système MEMS, une position qui résulte d'une phase de conception du micro-système MEMS, 1. Or, il n'est pas toujours possible de parvenir à placer tous les contacts électriques micro-système, 5 sur une zone périphérique de la deuxième face du micro-système MEMS. C'est pour cette raison que, pour pouvoir relier électriquement des contacts électriques micro-système, 5 et des contacts électriques internes, 16 il est nécessaire que les liaisons filaires, 20 atteignent des longueurs pouvant dépasser quelques millimètres.

Ceci est à l'origine de deux inconvénients :
Un premier inconvénient est lié à la longueur des liaisons filaires, 20 nécessaires pour relier les contacts électriques micro-système, 5 aux contacts électriques internes, 16, par exemple lorsque les contacts électriques micro-système, 5 sont situés dans une zone centrale de la deuxième face du micro-système, 1.

Les liaisons filaires, 20 sont souvent des fils métalliques de diamètre constant. Lorsqu'une liaison filaire, 20 a une longueur très grande devant son diamètre, typiquement, lorsque le rapport entre la longueur et le diamètre d'une liaison filaire, 20 dépasse un valeur de 50, la fragilité de la liaison filaire, 20 est grande : la liaison filaire, 20 est susceptible de se plier facilement, notamment lorsque le boîtier, 10 est soumis à de très fortes accélérations. Le pliage des liaisons filaires, 20 a pour effet de modifier considérablement la valeur des capacités apparaissant aux bornes des contacts électriques micro-système. Ceci constitue un inconvénient sérieux car, en général, le micro-système, 1 fonde ses mesures sur une détection de variations de capacités entre certains de ses contacts. Or, certains micro-systèmes sont destinés à être embarqué à bord d'un porteur soumis à une forte accélération, par exemple un aéronef ou un projectile et les modifications de capacités induites par les pliages des liaisons filaires, 20 ont une amplitude qui est grande devant les variations de capacités induites par les grandeurs physiques à mesurer.

Un deuxième inconvénient est également lié aux positions relatives occupées respectivement par les contacts électriques micro-système, 5 sur la deuxième face du micro-système MEMS, 1 et par les contacts électriques internes, 16 sur les parois internes du boîtier, 10. Dans certains cas, ces positions relatives requièrent que les liaisons filaires, 20 se chevauchent ou se croisent. Lorsque les boîtiers sont soumis à des accélérations très fortes, par exemple de l'ordre de 20000 g (où g est l'accélération terrestre), les liaisons filaires, 20 qui se croisent peuvent entrer en contact les unes avec les autres : ceci peut entraîner des court-circuits.

Le but de l'invention est de pallier ces inconvénients. Plus précisément l'invention a pour objet un boîtier de protection d'un micro-système électromécanique intégré audit boîtier, constitué de parois en matériau électriquement isolant, ledit boîtier formant une enceinte close, une paroi possédant une face interne dirigée vers l'intérieur de l'enceinte et une face externe en contact avec l'extérieur de l'enceinte, des contacts électriques internes étant disposés sur des faces internes, des contacts électriques externes étant disposés sur des faces externes, les contacts électriques internes et les contacts électriques externes étant reliés électriquement deux à deux, ledit micro-système étant sensiblement plan, une première face du micro-système étant fixée à une paroi interne du boîtier, une deuxième face du micro-système comportant des contacts électriques micro-système , une première extrémité d'une liaison filaire en matériau électriquement conducteur étant fixée au contact électrique micro-système , caractérisé en ce qu'il comporte un relais de câblage fixé à au moins une paroi interne, ledit relais étant constitué d'un matériau électriquement isolant et comportant des pistes en matériau électriquement conducteur, une piste étant reliée électriquement avec au moins un contact électrique interne et avec une deuxième extrémité d'une liaison filaire, ledit relais comportant en outre au moins un orifice traversé par la liaison filaire.

Un premier avantage de l'invention tient en ce qu'elle permet de relier des contacts électriques micro-système, 5 à des contacts électriques internes, 16 en employant des liaisons filaires, 20 qui ont une longueur relativement courte et qui, de fait, plient très rarement même lorsqu'elles sont soumises à des accélérations pouvant dépasser les 20000 g.

Un deuxième avantage de l'invention est lié à une simplification des règles de conception du micro-système. En effet, dans l'art antérieur, la position des contacts électriques micro-système, 5 sur la deuxième face du micro-système est contrainte par la position des contacts électriques internes, 16 sur les parois internes du boîtier, 10: ainsi, lors d'une conception d'un micro-système électromécanique MEMS, 1, on cherche d'une part à disposer les contacts électriques micro-système, 5 sur une zone périphérique de la deuxième face du micro-système et d'autre part à limiter les chevauchements, ou les croisements, entre liaisons filaires, 20 lorsque les règles de conception liées à la fabrication du micro-système le permettent. En employant un relais de câblage selon l'invention, il n'est plus nécessaire de confiner les contacts électriques micro-système, 5 sur la périphérie de la deuxième face du micro-système, il est aussi plus facile d'éviter des chevauchements de liaisons filaires, 20 : on allège ainsi considérablement des contraintes de conception du micro-système électromécanique.

Un troisième avantage de l'invention réside en ce que le relais de câblage selon l'invention peut, en outre, comporter des composants électroniques qui peuvent servir à mettre en oeuvre le micro-système, 1 ou encore pouvant servir à traiter des signaux électriques produits par le micro-système, 1.

D'autres caractéristiques et avantages de l'invention apparaîtront à la lecture de la description détaillée qui suit, faite à titre d'exemple non limitatif et en référence aux dessins annexés dans lesquels :
- la figure 1, déjà décrite, représente un boîtier de protection renfermant un micro-système électromécanique, en vue de coupe ;
- la figure 2 représente un boîtier de protection selon l'invention protégeant un micro-système électromécanique et comportant un relais de câblage selon l'invention ;
- la figure 3 représente, en vue perspective, un premier mode de réalisation d'un relais de câblage selon l'invention suivant une première face et une deuxième face ;
- la figure 4 représente, en vue perspective, un deuxième mode de réalisation d'un relais de câblage selon l'invention suivant une première face et une deuxième face ;

D'une figure à l'autre, les mêmes éléments sont repérés par les mêmes références.

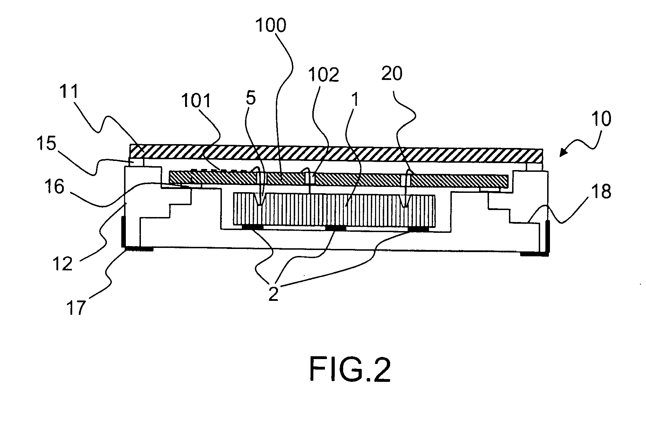

La figure 2 représente un boîtier protégeant un micro-système électromécanique, 1. Ce boîtier se distingue du boîtier présenté sur la figure 1, en ce qu'il comporte, en outre, un relais de câblage selon l'invention, 100.

Avantageusement, le relais de câblage selon l'invention est sensiblement plan.

Le relais de câblage se compose en général d'une plaque, 100 constituée d'un matériau isolant électrique. La plaque, 100 est en général fixée à au moins une paroi interne du boîtier, 10. La plaque comporte une première face et une deuxième face. Des pistes, 101, représentées en traits pointillés sur la figure, courent sur la première et la deuxième face de la plaque..

Les pistes, 101 sont constituées d'un matériau électriquement conducteur : par exemple, la plaque, 100 est en résine d'époxy et les pistes, 101 sont en cuivre. La plaque, 100 peut comporter des pistes, 101 qui courent sur plusieurs niveaux : on parle dans ce cas de pistes, 101 « multicouches ».

Les pistes, 101 comportent en général deux extrémités :
- une première extrémité, 105 qui est reliée électriquement aux contacts électriques internes, 16 qui sont disposés sur les parois internes du fond, 12 du boîtier, 10,
- une deuxième extrémité qui est liée à une des deuxièmes extrémités d'une liaison filaire, 20.

Les liaisons filaires, 20 comportent une première extrémité fixée à un contact électrique micro-système, 5 et une deuxième extrémité reliée électriquement à une deuxième extrémité des pistes, 101.

Avantageusement, une liaison filaire est un fil métallique de diamètre constant et en ce que le fil a une longueur qui est inférieure à cinquante fois le diamètre du fil.

Avantageusement, les liaisons filaires ont un diamètre égal à 25 micromètres.

Du fait de l'existence de pistes, 101 sur le relais de câblage selon l'invention, les liaisons filaires, 5 utilisées dans un boîtier de protection d'un micro-système électromécanique comportant un tel relais ont une longueur plus réduite que celle des liaisons filaires, 5 employées dans un boîtiers de protection dépourvu de relais de câblage.

La longueur réduite des liaisons filaire est à l'origine d'une résistance au pliage des liaisons filaires qui est élevée, même lorsqu'elles sont soumises à des accélérations de valeur pouvant aller à 20000 g.

Avantageusement, le relais de câblage selon l'invention est disposé de façon sensiblement parallèle à la deuxième face du composant micro-système et en ce qu'une première face du relais fait face à la deuxième face du composant.

Avantageusement, le relais de câblage selon l'invention comporte des orifices traversés par les liaisons filaires.

Pour monter le micro-système électromécanique, 1 dans le boîtier, on fixe tout d'abord le micro-système à une paroi du fond, 12 du boîtier 10. Dans un deuxième temps, on fixe le relais de câblage selon l'invention au fond, 12 du boîtier,1 de façon à ce que les premières extrémités des pistes, 101 soient électriquement reliées aux contacts électriques internes, 16.

On fixe ensuite les premières extrémités des liaisons filaires, 20 aux contacts électriques micro-système, 5. La fixation est réalisée en plaçant une première extrémité des liaisons filaires, 20 sur les contacts électriques micro-système 5 grâce à des outils de bondings dits « fond de puit ». Le placement est opéré en introduisant les outils et les liaisons filaires, 20 dans des orifices, 102 disposés au dessus des contacts électriques micro-système 5, à la verticale et à proximité directe de ces contacts, 5.

Puis, la deuxième extrémité des liaisons filaires est solidarisée à la deuxième extrémité d'une piste, 101 placée au moins partiellement sur une deuxième face du relais.

Enfin, le capot, 11 est fixé au fond du boîtier, 12, en général au moyen de brasures.

On peut établir dans l'enceinte formée par le capot 11 et par le fond 12 une atmosphère contrôlée.

Avantageusement, l'enceinte est close hermétiquement et un vide inférieur à 10⁻⁴ millibar règne dans l'enceinte.

Avantageusement, les pistes sont reliées aux deuxièmes extrémités des liaisons filaires sur une deuxième face dudit relais.

Avantageusement, un ratio entre une surface d'un orifice et une section droite d'une liaison filaire qui le traverse est supérieure à 1600.

Les orifices, 102 ont une surface suffisante pour que les outils de bondings de « fond de puit » introduits par ces orifices, 102, puissent atteindre les contacts électriques micro-système, 5.

Il est également indispensable qu'un orifice, 102 ait une surface suffisante pour qu'une liaison filaire, 20 le traversant n'entre pas en contact avec le relais de câblage. Par exemple, l'orifice, 102 a une forme circulaire et possède un diamètre égal à 1000 micromètres et la liaison filaire, 20 est un fil métallique de section droite qui possède un diamètre égal à 25 micromètres.

Avantageusement, le relais de câblage selon l'invention comporte en outre des composants électroniques qui sont reliés à des pistes.

On considère habituellement deux catégories de micro-systèmes, 1 :
- une première catégorie de micro-systèmes pouvant être qualifiés de perméables. Ces micro-systèmes ont des parois qui ne peuvent pas maintenir une atmosphère sous vide à l'intérieur du micro-système ;
- une deuxième catégorie de micro-systèmes pouvant être qualifié d'hermétiques. Ces micro-systèmes ont des parois qui peuvent conserver une atmosphère sous vide.

Des micro-systèmes, 1 appartenant à la première catégorie doivent nécessairement être protégés par des boîtiers qui sont eux mêmes hermétiques, c'est à dire que ce sont des boîtiers à l'intérieur desquels il est possible de maintenir une atmosphère sous vide. Le fonctionnement de tels micro-systèmes, 1 est altéré par une présence de composants électroniques disposés sur une ou des faces du relais de câblage pour fournir des signaux électriques servant au fonctionnement du micro-système ou pour traiter des signaux électriques produits par le micro-système. En effet, ces composants produisent des dégazages qui dégradent le vide fait dans l'enceinte.

Des micro-systèmes appartenant à la deuxième catégorie peuvent être enfermés dans des boîtiers de protection, 10 qui ne sont pas nécessairement totalement étanches, c'est à dire que ce sont des boîtiers à l'intérieur desquels règne une atmosphère neutre. Un fonctionnement du micro-système n'est pas altéré par des éventuels dégazages de composants électroniques disposés sur une des faces du relais.

Avantageusement, les composants électroniques produisent des signaux électriques employés pour faire fonctionner le micro-système.

Avantageusement, les composants électroniques recueillent des signaux électriques produits par le micro-système.

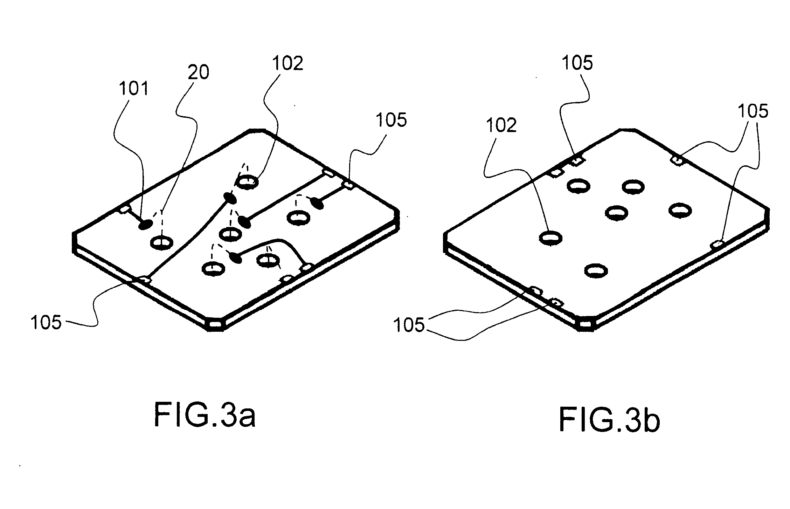

Les figures 3a et 3b représentent en vue perspective un premier mode de réalisation d'un relais de câblage selon l'invention. La figure 3a représente la deuxième face du premier mode de réalisation. La figure 3b représente la première face du premier mode de réalisation..

Ce mode de réalisation est préférentiellement adapté à un micro-système, 1 comportant un nombre peu élevé de contacts électriques micro-système, 5, par exemple lorsque le nombre de contacts électriques micro-système, 5 à relier à des contacts externes, 17 est inférieur ou égal à 6.

Pour ce mode de réalisation, qui correspond à la vue de coupe représentée sur la figure 2, une deuxième extrémité des pistes, 101, représentée par un disque noir, est placée sur la deuxième face du relais, à proximité d'un orifice 102 dans la plaque du relais.

Une liaison filaire, 5 représentée en traits pointillés possède une première extrémité, 105 solidarisée à un contact électrique micro-système, 5 : la première extrémité n'est pas représentée sur la figure 3a, et une deuxième extrémité qui est reliée à la deuxième extrémité des pistes, 101.

Les pistes, 101, relient leur deuxième extrémité à une première extrémité, 105, qui est représentée par un rectangle blanc sur la figure 3a. Les premières extrémités, 105 sont placées à proximité d'une zone périphérique de la plaque et sont traversantes, c'est à dire qu'elles apparaissent également sur une première face du relais de la plaque, 100 du relais.

Sur la figure 3b, on observe les premières extrémités, 105 des pistes, 101 qui occupent sur la plaque, 100, une position qui la met en contact avec des contacts électriques internes, 16 du boîtier, 10.

Une première étape d'assemblage du premier mode de réalisation du relais selon l'invention au fond, 12 du boîtier, 10 consiste à braser les contacts électriques internes, 16 non visibles sur la figures 3a et 3b, avec les deuxièmes extrémités, 105 des pistes, 101 pour d'une part fixer le relais au boîtier et d'autre part, pour relier électriquement les contacts électriques externes, 17 et les deuxièmes extrémités des pistes, 101.

Une deuxième étape d'assemblage du relais au fond du boîtier, 10 consiste à fixer les deux extrémités des liaisons filaires, 20 comme présenté plus haut, respectivement aux contacts électriques micro-système et aux deuxièmes extrémités des pistes, 101.

La forme de la plaque, 100 est conformée pour autoriser une introduction dans le boîtier du relais selon l'invention.

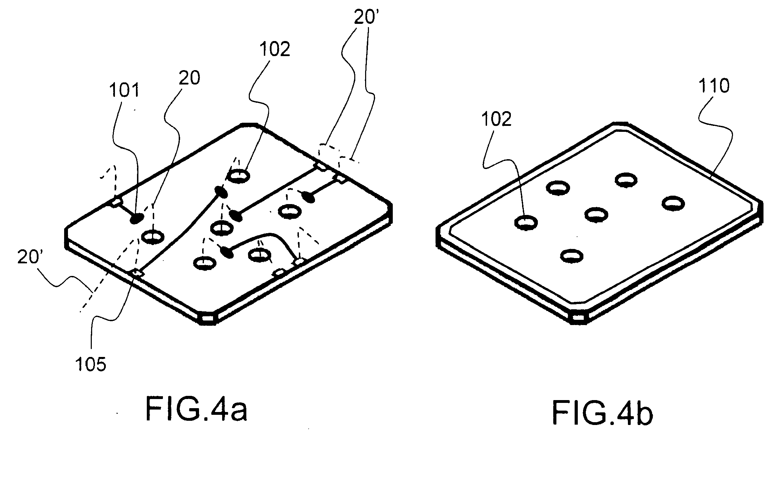

Les figures 4a et 4b représentent en vue perspective un deuxième mode de réalisation d'un relais de câblage selon l'invention. La figure 4a représente la deuxième face du deuxième mode de réalisation. La figure 4b représente la première face du deuxième mode de réalisation.

Ce mode de réalisation est préférentiellement adapté à un micro-système, 1 comportant un nombre élevé de contact électrique micro-système, 5, par exemple lorsque le nombre de contacts micro-systèmes à relier à des contacts externes est supérieur ou égal à 6.

La deuxième face du deuxième mode de réalisation du relais se distingue de la deuxième face du premier mode de réalisation, en ce que les pistes 101, se prolongent par des liaisons filaires annexes 20' et en ce que les premières extrémités, 105 des pistes, 101 ne sont pas traversantes.

Une extrémité des liaisons filaires annexes 20' est liée à la première extrémité, 105 de la piste, 101, qui est représentée par un rectangle blanc sur la figure 4a. La première extrémité, 105 est placée à proximité des bords de la plaque, 100.

La première face du deuxième mode de réalisation du relais diffère de la première face du premier mode de réalisation du relais selon en ce qu'elle comporte une zone de brasage, 110 couvrant des bords de la plaque, 100.

Une première étape d'assemblage du deuxième mode de réalisation du relais selon l'invention au fond du boîtier consiste à solidariser la plaque et le fond 12, du boîtier, 100 en déposant du matériau de brasage sur la zone de brasage 110.

Une deuxième étape d'assemblage du relais consiste à fixer deux extrémités des liaisons filaires, 20 comme présenté plus haut respectivement aux contacts électriques micro-système, 1 et aux deuxièmes extrémités des pistes, 101.

Une troisième étape d'assemblage consiste à fixer deux extrémités des liaisons filaires auxiliaires, 20' respectivement aux contacts internes, 16 et aux premières extrémités, 105 de la piste, 101.

Lorsque un micro-systèmes comporte un nombre élevé de contacts électriques micro-systèmes, 5 et que les deuxièmes extrémités, 105 des piste 101 sont nombreuses et très proches les unes des autres, il est plus aisé d'assembler ce deuxième mode de réalisation du relais, à un fond, 12 du boîtier, 10 que le premier mode de réalisation.

En effet, l'assemblage du premier mode de réalisation du relais selon l'invention au fond, 12 d'un boîtier, 10 est très délicate à réaliser en raison de la difficulté à déposer du matériau de brasage sur des deuxièmes extrémités, 105 très proches les unes des autres, par exemple, lorsque ces deuxièmes extrémités, 105 sont séparées de quelques dizaines de micromètres.

## Revendications

1. Boîtier de protection d'un micro-système électromécanique (1) intégré audit boîtier, constitué de parois en matériau électriquement isolant, ledit boîtier (10) formant une enceinte close, une paroi possédant une face interne dirigée vers l'intérieur de l'enceinte et une face externe en contact avec l'extérieur de l'enceinte, des contacts électriques internes (16) étant disposés sur des faces internes, des contacts électriques externes (17) étant disposés sur des faces externes, les contacts électriques internes (16) et les contacts électriques externes (17) étant reliés électriquement deux à deux, ledit micro-système étant sensiblement plan, une première face du micro-système (1) étant fixée à une paroi interne du boîtier (10), une deuxième face du micro-système (1) comportant des contacts électriques micro-système (5), une première extrémité d'une liaison filaire (20) en matériau électriquement conducteur étant fixée au contact électrique micro-système (5), **caractérisé en ce qu'**il comporte un relais de câblage fixé à au moins une paroi interne, ledit relais étant constitué d'un matériau électriquement isolant et comportant des pistes (101) en matériau électriquement conducteur, une piste (101) étant reliée électriquement avec au moins un contact électrique (16) interne et avec une deuxième extrémité d'une liaison filaire (20), ledit relais comportant en outre au moins un orifice (102) traversé par la liaison filaire (20).

2. Boîtier de protection d'un micro-système électromécanique selon la revendication 1, **caractérisé en ce que** le relais de câblage est disposé de façon sensiblement parallèle à la deuxième face du micro-système (1) et **en ce qu'**une première face du relais fait face à la deuxième face du micro-système (1).

3. Boîtier de protection d'un micro-système électromécanique selon l'une des revendications précédentes **caractérisé en ce que** les pistes (101) sont reliées aux deuxièmes extrémités des liaisons filaires (20) sur une deuxième face dudit relais.

4. Boîtier de protection d'un micro-système électromécanique selon l'une des revendications précédentes caractérisé qu'un ratio entre une surface d'orifice (102) et une section droite d'une liaison filaire (20) qui traverse l'orifice est supérieur à 1600.

5. Boîtier de protection d'un micro-système électromécanique selon l'une des revendications précédentes, **caractérisé en ce que** le relais de câblage comporte, en outre, des composants électroniques qui sont reliés électriquement à des pistes (101).

6. Boîtier de protection d'un micro-système électromécanique selon la revendication 5 **caractérisé en ce que** les composants électroniques produisent des signaux électriques employés pour faire fonctionner le micro-système (1).

7. Boîtier de protection d'un micro-système électromécanique selon la revendication 6, **caractérisé en ce que** les composants électroniques recueillent des signaux électriques produits par le micro-système (1).

8. Boîtier de protection selon l'une des revendications précédentes **caractérisé en ce qu'**une liaison filaire (5) est un fil métallique de diamètre constant et **en ce que** le fil a une longueur qui est inférieure à cinquante fois le diamètre du fil.

9. Boîtier de protection selon l'une des revendications 1 à 8 **caractérisé en ce que** l'enceinte est close hermétiquement et **en ce qu'**un vide inférieur à 10⁻⁴ millibar règne dans l'enceinte.

10. Boîtier de protection selon l'une des revendications précédentes **caractérisé en ce que** les liaisons filaires (5) ont un diamètre égal à 25 micromètres.

## Claims

1. Protection casing for an electromechanical microsystem (1) integrated in the casing, which is constituted by walls of electrically insulating material, the casing (10) forming a closed chamber, a wall having an internal face directed towards the inner side of the chamber and an external face in contact with the outer side of the chamber, internal electrical contacts (16) being arranged on internal faces, external electrical contacts (17) being arranged on external faces, the internal electrical contacts (16) and the external electrical contacts (17) being electrically connected in pairs, the microsystem being substantially planar, a first face of the microsystem (1) being fixed to an internal wall of the casing (10), a second face of the microsystem (1) comprising microsystem electrical contacts (5), a first end of a wire connection (20) of electrically conductive material being fixed to the microsystem electrical contact (5), **characterised in that** it comprises a cabling relay which is fixed to at least one internal wall, the relay being constituted by an electrically insulating material and comprising tracks (101) of electrically conductive material, a track (101) being electrically connected to at least one internal electrical contact (16) and to a second end of a wire connection (20), the relay further comprising at least one aperture (102) through which the wire connection (20) extends.

2. Protection casing for an electromechanical microsystem according to claim 1, **characterised in that** the cabling relay is arranged in a manner substantially parallel with the second face of the microsystem (1) and **in that** a first face of the relay faces the second face of the microsystem (1).

3. Protection casing for an electromechanical microsystem according to either of the preceding claims, **characterised in that** the tracks (101) are connected to the second ends of the wire connections (20) on a second face of the relay.

4. Protection casing for an electromechanical microsystem according to any one of the preceding claims, **characterised in that** a ratio between a surface-area of an aperture (102) and a cross-section of a wire connection (20) which extends through the aperture is greater than 1600.

5. Protection casing for an electromechanical microsystem according to any one of the preceding claims, **characterised in that** the cabling relay further comprises electronic components which are electrically connected to tracks (101).

6. Protection casing for an electromechanical microsystem according to claim 5, **characterised in that** the electronic components produce electrical signals which are used to operate the microsystem (1).

7. Protection casing for an electromechanical microsystem according to claim 6, **characterised in that** the electronic components acquire electrical signals produced by the microsystem (1).

8. Protection casing according to any one of the preceding claims, **characterised in that** a wire connection (5) is a metal wire having a constant diameter and **in that** the wire has a length which is less than 50 times the diameter of the wire.

9. Protection casing according to any one of claims 1 to 8, **characterised in that** the chamber is hermetically sealed and **in that** reduced pressure of less than 10⁻⁴ millibar is present in the chamber.

10. Protection casing according to any one of the preceding claims, **characterised in that** the wire connections (5) have a diameter of 25 micrometres.

## Patentansprüche

1. Schutzkasten für ein elektromechanisches Mikrosystem (1), das in den Kasten integriert ist, der aus Wänden aus elektrisch isolierendem Material besteht, wobei der Kasten (10) einen geschlossenen Behälter bildet, wobei eine Wand eine Innenfläche besitzt, die in den Behälter gerichtet ist und eine Außenfläche im Kontakt mit der Außenwelt des Behälters, wobei interne elektrische Kontakte (16) auf Innenflächen angeordnet sind, wobei externe elektrische Kontakte (17) auf Außenflächen angeordnet sind, wobei die internen elektrischen Kontakte (16) und die externen elektrischen Kontakte (17) paarweise elektrisch verbunden sind, wobei das Mikrosystem etwa eben ist, wobei eine erste Fläche des Mikrosystems (1) an einer Innenwand des Kastens (10) befestigt ist, wobei eine zweite Fläche des Mikrosystems (1) elektrische Mikrosystemkontakte (5) aufweist, wobei ein erstes Ende einer Drahtverbindung (20) aus elektrisch leitendem Material am elektrischen Mikrosystemkontakt (5) befestigt ist, **dadurch gekennzeichnet, dass** er ein Verkabelungsrelais aufweist, das an mindestens einer Innenwand befestigt ist, wobei das Relais aus einem elektrisch isolierendem Material besteht und Spuren (101) aus elektrisch leitendem Material aufweist, wobei eine Spur (101) mit mindestens einem internen elektrischen Kontakt (16) und mit einem zweiten Ende einer Drahtverbindung (20) elektrisch verbunden ist, wobei das Relais ferner mindestens eine Öffnung (102) aufweist, die von der Drahtverbindung (20) durchquert wird.

2. Schutzkasten für ein elektromechanisches Mikrosystem nach Anspruch 1, **dadurch gekennzeichnet, dass** das Verkabelungsrelais etwa parallel zur zweiten Fläche des Mikrosystems (1) angeordnet ist und dass eine erste Fläche des Relais der zweiten Fläche des Mikrosystems (1) gegenüberliegt.

3. Schutzkasten für ein elektromechanisches Mikrosystem nach einem der vorangehenden Ansprüche, **dadurch gekennzeichnet, dass** die Spuren (101) mit den zweiten Enden der Drahtverbindungen (20) über eine zweite Fläche des Relais verbunden sind.

4. Schutzkasten für ein elektromechanisches Mikrosystem nach einem der vorangehenden Ansprüche, **dadurch gekennzeichnet, dass** ein Verhältnis zwischen einer Öffnungsfläche (102) und einem Querschnitt einer Drahtverbindung (20), die die Öffnung durchquert, größer als 1600 ist.

5. Schutzkasten für ein elektromechanisches Mikrosystem nach einem der vorangehenden Ansprüche, **dadurch gekennzeichnet, dass** das Verkabelungsrelais ferner elektronische Bauteile aufweist, die mit Spuren (101) elektrisch verbunden sind.

6. Schutzkasten für ein elektromechanisches Mikrosystem nach Anspruch 5, **dadurch gekennzeichnet, dass** die elektronischen Bauteile elektrische Signale produzieren, die für die Funktion des Mikrosystems (1) verwendet werden.

7. Schutzkasten für ein elektromechanisches Mikrosystem nach Anspruch 6, **dadurch gekennzeichnet, dass** die elektronischen Bauteile elektrische Signale aufnehmen, die das Mikrosystem (1) produziert.

8. Schutzkasten nach einem der vorangehenden Ansprüche, **dadurch gekennzeichnet, dass** eine Drahtverbindung (5) ein Metalldraht mit einem konstanten Durchmesser ist und dass der Draht eine Länge hat, die kleiner ist als fünfzig Mal der Durchmesser des Drahts.

9. Schutzkasten nach einem der Ansprüche 1 bis 8, **dadurch gekennzeichnet, dass** der Behälter hermetisch geschlossen ist und dass in dem Behälter ein Vakuum unter 10⁻⁴ Millibar herrscht.

10. Schutzkasten nach einem der vorangehenden Ansprüche, **dadurch gekennzeichnet, dass** die Drahtverbindungen (5) einen Durchmesser von gleich 25 Mikrometer haben.
